(19) Europäisches Patentamt
European Patent Office
Office européen des brevets

(11) Publication number: **0 231 522 B1**

# (12) EUROPEAN PATENT SPECIFICATION

(45) Date of publication of patent specification: **04.12.91**

(51) Int. Cl.⁵: **G03F 7/09**

(21) Application number: **86118103.0**

(22) Date of filing: **29.12.86**

## (54) Antireflective photoresist composition.

(30) Priority: **27.01.86 US 822440**

(43) Date of publication of application:
**12.08.87 Bulletin 87/33**

(45) Publication of the grant of the patent:
**04.12.91 Bulletin 91/49**

(84) Designated Contracting States:
**DE FR GB NL**

(56) References cited:
**EP-A- 0 029 412**
**EP-A- 0 101 295**
**US-A- 4 420 555**

**MICROELECTRONIC ENGINEERING, vol. 3, no. 1/4, December 1985, pages 321-328, Elsevier Science Publishers B.V., Amsterdam, NL; M. BOLSEN: "To dye or not to dye - Some aspects of today's resist technology"**

(73) Proprietor: **EASTMAN KODAK COMPANY (a New Jersey corporation)**
**343 State Street**
**Rochester New York 14650(US)**

(72) Inventor: **DoMinh, Thap**
**Kodak Park**
**Rochester New York 14650(US)**
Inventor: **Diehl, Donald Richard**
**Kodak Park**
**Rochester New York 14650(US)**

(74) Representative: **Parent, Yves et al**
**Kodak-Pathé Département Brevets et Licences Centre de Recherches et de Technologie Zone Industrielle**
**F-71102 Chalon-sur-Saône Cédex(FR)**

**EP 0 231 522 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a photoresist composition and a method of use, and particularly to such a composition and method adapted to be immune to radiation reflected from the support on which the composition is coated.

A frequent problem encountered by resists used to process supports comprising semiconductor devices, is reflectivity back into the resist of the activating radiation by the support, especially those containing highly reflecting topographies. Such reflectivity tends to cause standing wave ripples and reflective notchings, which interfere with the desired pattern in the photoresist. The notchings are particularly severe when the support is non-planar. The conventional approach to this problem is to incorporate an antireflective dye either in the photosensitive layer or an adjacent layer. The incorporation of the dye directly into the photoresist layer is particularly attractive, since this minimizes the need for laying down an extra layer.

Although there are many dyes known to be antireflective from their use as, e.g., antihalation dyes in the silver halide photography art, it is not possible to transfer such dyes wholesale to the photoresist arena. There are conditions peculiar to the photoresist art which render many such dyes unsuitable. One of these is the high temperature baking that is given to the resist, prior to its exposure. For example, it is common to force either the photoresist layer or the antireflective layer into a planar configuration by baking it until it melts and flows, creating a condition known as "planarizing." Such baking can require temperatures as high as 200° C. Unless care is taken in the selection of the dyes, such high temperatures are deleterious in at least this respect: Because the antireflective layer is very thin, e.g., no greater than about 5 µm, the dyes tend to volatilize out of the layer, particularly if they are not so large in molecular weight as to be mordanted. It is true, of course, that some loss can be compensated for by adding more dye to the photoresist layer than would otherwise be needed. However, this is useful only up to a limit of about 15% density loss upon baking. The reasons are that higher dye loading causes greater speed losses, and most dyes are not sufficiently soluble as to permit more than a 15% overload of dye into the resist.

Still another problem that arises when the dye is within the photoresist layer is that absorption by such dye tends to cause a speed loss, due to its absorption of activating radiation. Prior to this invention, it has not been clear how the dye could be antireflective without also producing significant net loss in speed.

These problems are solved by providing a photoresist composition suitable for pre-exposure baking as a layer having a thickness no greater than 5. µm, at 200° C for 10 minutes, said composition comprising a positive-working, non-silver halide, photosensitive compound and an antireflecting dye that absorbs at least some of the radiation that is effective to activate said compound. The composition is characterized in that the dye has the following structural formula:

I

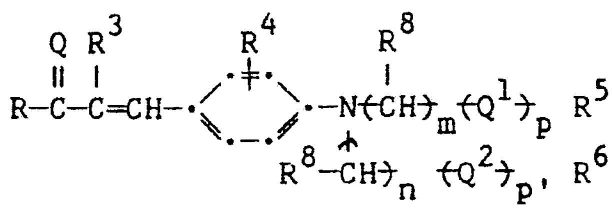

wherein:

R is alkyl of 1-3 carbon atoms or

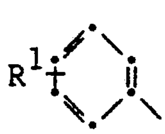

$R^1$ is $R^2SO_2NH$-, $R^2NHSO_2$-, HO-, or $HO_2C$-;

$R^2$ is alkyl of 1-6 carbon atoms or such alkyl substituted with fluorine, or aryl of 6-10 carbon atoms;

Q is =O or =N- joined with $R^3$ to complete a pyrazolone ring;

$R^3$ is -CN, -$NO_2$, -$CF_3$, or

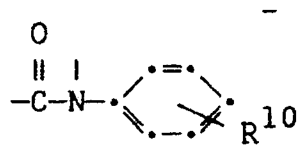

joined with Q to complete said pyrazolone ring;

$R^4$ is H, alkyl of 1-6 carbon atoms; or

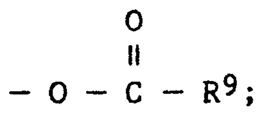

$R^5$ and $R^6$ are individually alkyl of 1-5 carbon atoms optionally substituted with fluorine, $-R^7$, or H;

$Q^1$ and $Q^2$ are individually $-CO_2-$, $-O_2C-$ or $-SO_2-$;

$R^7$ is alkyl of 1-3 carbon atoms or aryl of 6-10 carbon atoms;

$R^8$ is H or alkyl of 1-3 carbon atoms;

$R^9$ is H or alkyl of 1-7 carbon atoms;

$R^{10}$ is $-NHSO_2-R^7$ or H;

m and n are individually an integer of from 1 to 5; and

p and p' are individually 0 or 1.

Such a resist composition provides a method of preventing standing wave ripples and reflective notching from occurring in the composition from radiation reflected back from a support on which the composition is coated.

An important aspect of this invention is that the photoresist composition and method of use of the invention have unexpected resistance to significant dye volatilization at baking temperatures of at least 200°C. As used herein, "resistance to significant dye volatilization" means, less than 15% decrease in density when heated at 200°C for 10 minutes, over the exposure region of interest.

Thus, it is an advantageous feature of the invention that an antireflecting, positive-working photoresist composition is provided that, as a layer having a thickness $\leq$ 5 $\mu$m, has no more than 15% density loss when heated at 200°C for 10 minutes.

It is another, and unexpected advantageous feature of the invention that such a composition has very little speed loss when fully developed, in spite of the absorbancy by the dye of activating radiation.

The description which follows concerns usage of the preferred embodiments as a photoresist, over semiconductor supports. In addition, the invention is applicable as a thermally-resistant antireflecting layer whether or not the photoresist is used over semiconductor supports or substrates.

The photoresist composition of the invention includes any positive-working, photosensitive compound, optionally any suitable binder, and the antireflecting dye of structural formula I.

As used herein, a "positive-working photosensitive compound" means any compound, be it a polymer or not, which is responsive to activating radiation of any kind to produce a positive-working image after development of the resist. Thus, it includes those that respond to X-ray or E-beam radiation as well as those that respond to light. If the photosensitive compound is not a polymer, it is conventional practice to include a polymeric binder.

It will be readily apparent that the selection of such photosensitive compound depends upon the activating radiation of choice. Useful non-limiting examples of such photosensitive compounds include quinone diazide compounds and resins, for example, quinone diazide sulfonated compounds (NDS) or NDS-capped novolac resins or polymers wherein up to 15 mole % of the hydroxyl groups are capped with quinone diazide, to have the general structural formula:

A

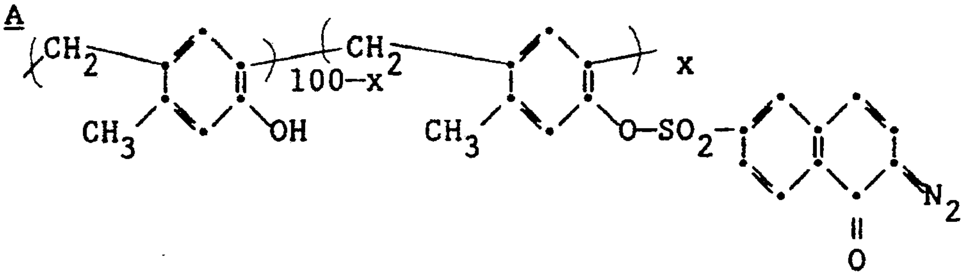

wherein x is up to 15 mole %.

Other useful photosensitive compounds include poly(methyl methacrylate-co-methacrylic acid)$_{x:y}$, wherein x varies from 80 to 90 mole %, and the homopolymer of poly(methyl methacrylate.) The latter two examples are responsive to deep UV radiation.

The photoresist composition of the invention can optionally include a variety of conventional addenda, examples of which are readily obtainable from the literature.

In accord with one aspect of the invention, the dye which provides the antireflecting properties is selected to have the structural formula I above. In that formula, useful examples of the alkyl in $R^2$ and $R^4$ include methyl, ethyl, propyl, i-propyl, hexyl, and the like. In $R^2$, alkyl also includes such examples substituted with fluorine, e.g., trifluoromethyl, 2-trifluoroethyl, and the like. The aryl in $R^2$ includes phenyl and naphthyl. Examples of the alkyl in $R^5$ and $R^6$ include methyl, ethyl, propyl, isopropyl, butyl, pentyl, and the like, and such alkyls substituted with fluorine, e.g., fluoromethyl, trifluoromethyl, 2-trifluoromethyl and the like. The examples of aryl in $R^7$ include phenyl and naphthyl. The examples of alkyl in $R^8$ include methyl, ethyl, propyl and i-propyl, and for $R^9$ alkyl includes these as well as butyl, hexyl, heptyl, and the like.

The features of formula I are considered to be important in providing a reduction in volatility, enhanced base solubility upon development of the resist, absorbance of activating radiation, and ease in synthesis. For example, it is believed resistance to volatilization is due in part to the semi-ionic nature of the dye arising from the charge separation due to resonance, viz:

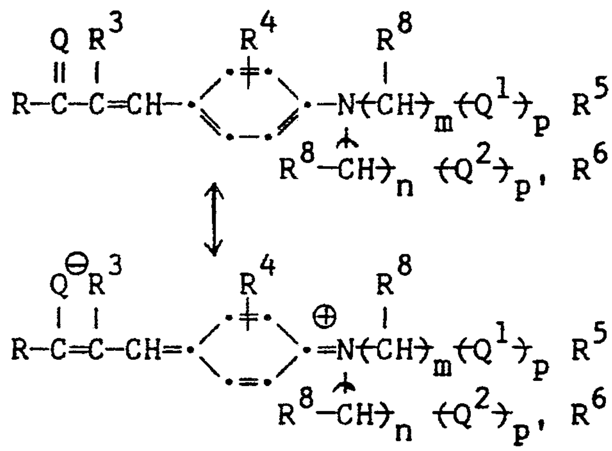

The base solubility is particularly important, because the enhancement in development provided by the solubility of the dye is the feature that overcomes the loss in speed due to the radiation absorption.

A wide variety of specific dyes is included within structural formula I. Examples of these dyes are included in the discussion of dye preparation.

Generally, such dyes have a wavelength of maximum absorption, $\lambda_{max}$ (measured in methanol) that varies between about 410 and about 450 nm. Particularly preferred are those dyes having a $\lambda_{max}$ that is from 420 to 430 nm. The dyes of this subset of the class of dyes of formula I, have the following structural formula:

IIA

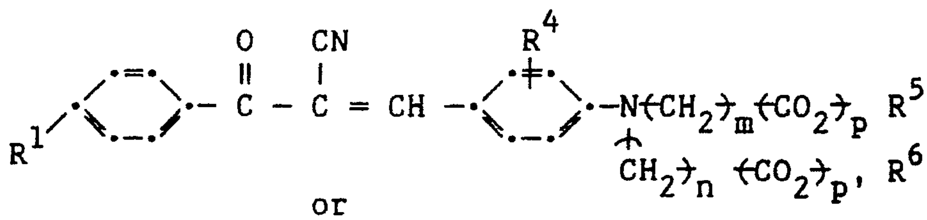

or

IIB

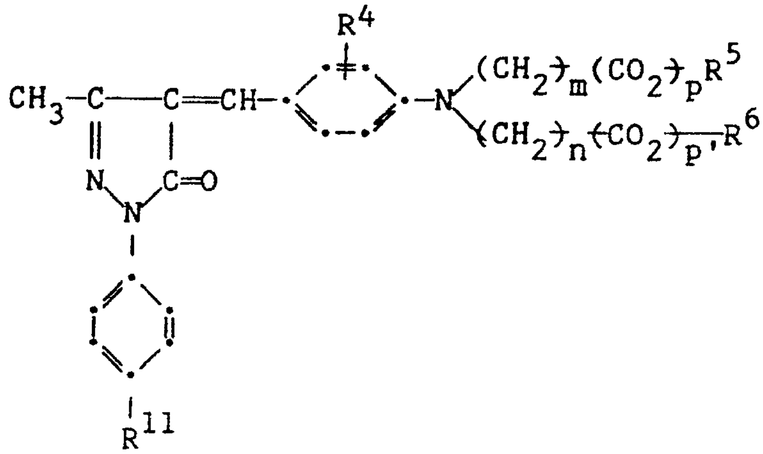

wherein:

$R^1$ is $R^2SO_2NH$-;

$R^2$ is alkyl of 1-6 carbon atoms;

$R^4$ is H or alkyl of 1-6 carbon atoms;

$R^5$ and $R^6$ are individually alkyl of 1-3 carbon atoms or alkyl of 1-3 carbon atoms substituted with fluorine;

$R^{11}$ is

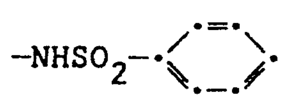

or H;

m and n are 1 or 2; and

p and p' are 0 or 1.

Highly preferred members of this subset include:

a) α-cyano-4-[N-ethyl-N-(2,2,2-trifluoroethoxycarbonylmethyl)]amino-2-methyl-4'-propylsulfonamidochalcone;

b) α-cyano-4-[N,N-di(isopropoxycarbonylmethyl)]amino-2-methyl-4'-methylsulfonamidochalcone;

c) α-cyano-4-[N-ethyl-N-(2,2,2-trifluoroethoxycarbonylmethyl)]amino-4'-butylsulfonamidochalcone;

d) α-cyano-4-[N-ethyl-N-(2,2,2-trifluoroethoxycarbonylmethyl)]amino-2-methyl-4'-butylsulfonamidochalcone;

e) α-cyano-4-[N-isopropyl-N-isopropoxycarbonylmethyl]amino-4'-propylsulfonamidochalcone;

f) α-cyano-4-[N,N-di(2-fluoroethyl)]amino-4'-butylsulfonamidochalcone;

g) α-cyano-4-[N,N-di(2-fluoroethyl)]amino-4'-isobutylsulfonamidochalcone;
h) α-cyano-4-[N,N-di(2-fluoroethyl)]amino-4'pentylsulfonamidochalcone;
i) α-cyano-4-[N,N-di(2-fluoroethyl)]amino-4'-hexylsulfonamidochalcone;
j) α-cyano-4-[N,N-di(isopropoxycarbonylmethyl)]amino-2-methyl-4'-ethylsulfonamidochalcone;
k) α-cyano-4-[N-(2-isopropoxycarbonylethyl)-N-isopropoxycarbonylmethyl]amino-4'-ethylsulfonamidochalcone;
l) 4-[4-di-(isopropoxycarbonylmethyl)amino-2-benzylidene]-3-methyl-1-(4-phenylsulfonamido)phenyl-2-pyrazolin-5-one.

## Dye Preparation

The dyes of this composition are synthesizable by conventional techniques. Many can be synthesized by either:

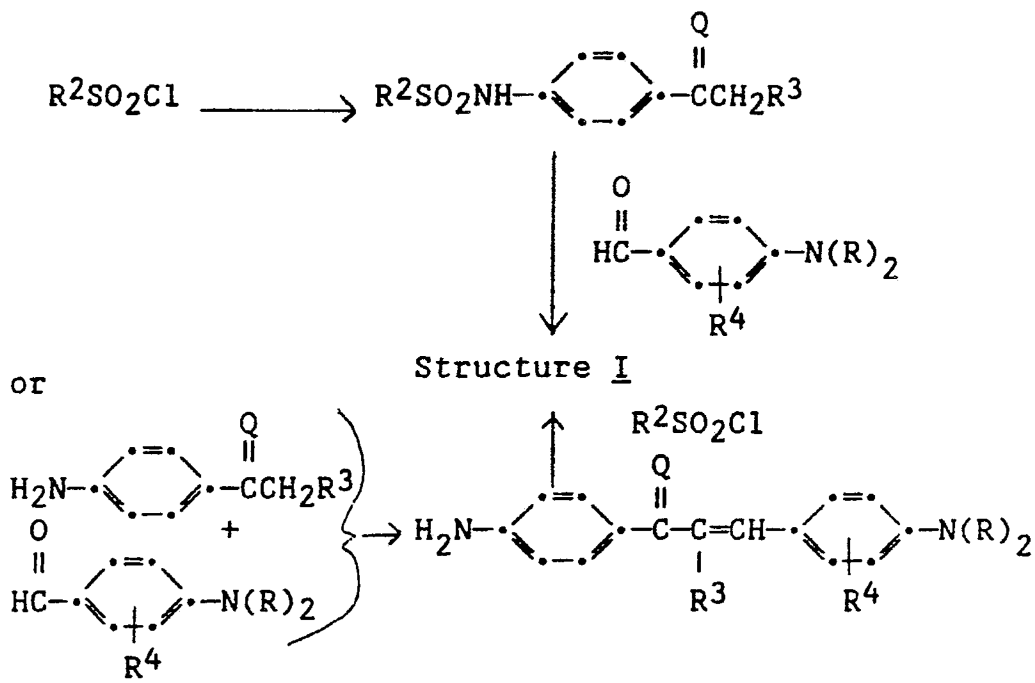


Further details can be found in U.S. Patent No. 4,420,555.

The following dyes useful in the composition of the invention were prepared by the above techniques.

**Table I - Dye Preparation**

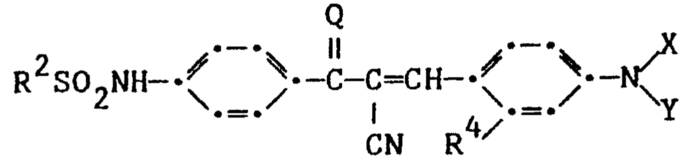

| Preparation No. | X | Y | Q | $R^2$ | $R^4$ | Yield (%) | MP(°C) | MeOH $\lambda_{max}$ |
|---|---|---|---|---|---|---|---|---|
| 1 | $CH_3$ | $CH_3$ | O | $CH_3$ | H | 65 | 211–212 | 445 |
| 2 | $CH_3$ | $CH_3$ | O | $n-C_6H_{13}$ | H | 80 | 150–151 | 44(?) |
| 3 | $CH_3$ | $CH_3$ | O | $CF_3$ | H | 82 | 186–188 | 440 |
| 4 | $CH_3$ | $CH_3$ | O | $n-C_4H_9$ | $CH_3$ | 80 | 137–139 | 455 |
| 5 | $CH_3$ | $CH_3$ | O | $C_2H_5$ | $O\overset{O}{\overset{\Vert}{C}}C_7H_{15}$ | 30 | 124–126 | 440 |
| 6 | $CH_3$ | $n-C_3H_7$ | O | $CF_3$ | H | 96 | 131–133 | 445 |
| 7 | $CH_3$ | $i-C_5H_{11}$ | O | $CH_3$ | H | 43 | 143–145 | 450 |
| 8 | $CH_3$ | $i-C_5H_{11}$ | O | $C_2H_5$ | H | 68 | 138–139 | 450 |
| 9 | $CH_3$ | $i-C_5H_{11}$ | O | $n-C_4H_9$ | H | 71 | 113–114 | 448 |

Table I (cont.)

| Preparation No. | X | Y | Q | $R^2$ | $R^4$ | Yield (%) | MP(°C) | MeOH $\lambda_{max}$ |
|---|---|---|---|---|---|---|---|---|
| 10 | $CH_3$ | $i-C_5H_{11}$ | 0 | $CF_3$ | H | 80 | 149–151 | 446 |
| 11 | $CH_3$ | $CH_2CH(C_2H_5)_2$ | 0 | $CH_3$ | H | 82 | 150–151 | 450 |
| 12 | $C_2H_5$ | $C_2H_5$ | 0 | $n-C_4H_9$ | H | 16 | 142–144 | 455 |
| 13 | $C_2H_5$ | $C_2H_5$ | 0 | $n-C_6H_{13}$ | H | 82 | 148–149 | 453 |
| 14 | $C_2H_5$ | $C_2H_5$ | 0 | $C_2H_5$ | $O\overset{O}{\overset{\|}{C}}CH_3$ | 26 | 140–143 | 445 |
| 15 | $C_2H_5$ | $C_2H_5$ | 0 | $C_2H_5$ | $O\overset{O}{\overset{\|}{C}}C_4H_9$ | 33 | 152–154 | 446 |
| 16 | $C_2H_5$ | $CH_2CO_2CH_2CF_3$ | 0 | $n-C_4H_9$ | H | 77 | 158–159 | 423 |
| 17 | $C_2H_5$ | $CH_2CO_2CH_2CF_3$ | 0 | $C_2H_5$ | $CH_3$ | 56 | 147–149 | 431 |
| 18 | $C_2H_5$ | $CH_2CO_2CH_2CF_3$ | 0 | $n-C_3H_7$ | $CH_3$ | 73 | 144–145 | 430 |
| 19 | $C_2H_5$ | $CH_2CO_2CH_2CF_3$ | 0 | $n-C_4H_9$ | $CH_3$ | 56 | 118–120 | 430 |
| 20 | $C_2H_5$ | $CH_2CO_2C_3H_7-i$ | 0 | $n-C_4H_9$ | $CH_3$ | 84 | 133–135 | 437 |

Table I (cont.)

| Preparation No. | X | Y | Q | $R^2$ | $R^4$ | Yield (%) | MP(°C) | MeOH $\lambda_{max}$ |
|---|---|---|---|---|---|---|---|---|
| 21 | $C_2H_5$ | $CH_2CO_2C_3H_7$-i | O | n-$C_4H_9$ | $C_2H_5$ | 48 | 124–125 | 434 |
| 22 | $C_2H_5$ | $CH_2CH_2CO_2C_3H_7$-i | O | $C_2H_5$ | $CH_3$ | 49 | 121–123 | 445 |
| 23 | $C_2H_5$ | $CH_2CH_2CO_3C_3H_7$-i | O | n-$C_3H_7$ | $CH_3$ | 64 | 132–135 | 446 |
| 24 | $C_2H_5$ | $CH_2CH_2CO_2C_4H_9$-i | O | $C_2H_5$ | H | 59 | 113–115 | 436 |
| 25 | $C_2H_5$ | $CH_2CH_2CO_2CH_2CF_3$ | O | $C_2H_5$ | H | 32 | 133–134 | 435 |
| 26 | $C_2H_5$ | $CH_2CH_2CO_2CH_2CF_3$ | O | n-$C_4H_9$ | H | 60 | 102–104 | 435 |
| 27 | $C_2H_5$ | $CH_2CH_2CO_2CH_2CF_3$ | O | $CH_3$ | $CH_3$ | 20 | 131–132 | 444 |
| 28 | $C_2H_5$ | $CH_2CH_2CO_2CH_2CF_3$ | O | $C_2H_5$ | $CH_3$ | 42 | 103–105 | 443 |
| 29 | $C_2H_5$ | $CH(CH_3)CH_2CO_2C_2H_5$ | O | $C_2H_5$ | H | 50 | 102–103 | 440 |
| 30 | $C_2H_5$ | $CH_2CH_2O_2CC_3H_7$-i | O | $C_2H_5$ | H | 66 | 111–113 | 438 |
| 31 | $C_2H_5$ | $CH_2CH_2O_2CC_3H_7$-i | O | n-$C_4H_9$ | H | 58 | 99–101 | 435 |
| 32 | i-$C_3H_7$ | $CH_2CO_2C_3H_7$-i | O | n-$C_3H_7$ | H | 62 | 121–123 | 430 |

Table I (cont.)

| Preparation No. | X | Y | Q | $R^2$ | $R^4$ | Yield (%) | MP(°C) | MeOH $\lambda_{max}$ |
|---|---|---|---|---|---|---|---|---|
| 33 | $n-C_3H_7$ | $CH_2CO_2CH_2CF_3$ | O | $n-C_3H_7$ | $CH_3$ | 70 | 164–166 | 432 |
| 34 | $CH_2CH_2F$ | $CH_2CH_2F$ | O | $n-C_4H_9$ | H | 84 | 123–124 | 429 |
| 35 | $CH_2CH_2F$ | $CH_2CH_2F$ | O | $i-C_4H_9$ | H | 71 | 157–158 | 430 |
| 36 | $CH_2CH_2F$ | $CH_2CH_2F$ | O | $n-C_5H_{11}$ | H | 58 | 134–135 | 430 |
| 37 | $CH_2CH_2F$ | $CH_2CH_2F$ | O | $n-C_6H_{13}$ | H | 83 | 120–122 | 430 |
| 38 | $CH_2CO_2C_2H_5$ | $CH_2CO_2C_2H_5$ | O | $C_2H_5$ | H | 57 | 125–126 | 410 |
| 39 | $CH_2CO_2C_2H_5$ | $CH_2CO_2C_2H_5$ | O | $n-C_4H_9$ | H | 28 | 119–121 | 410 |
| 40 | $CH_2CO_2C_3H_7-i$ | $CH_2CO_2C_3H_7-i$ | O | $C_2H_5$ | H | 72 | 133–135 | 410 |
| 41 | $CH_2CO_2C_3H_7-i$ | $CH_2CO_2C_3H_7-i$ | O | $n-C_4H_9$ | H | 72 | 108–110 | 410 |
| 42 | $CH_2CO_2C_3H_7-i$ | $CH_2CO_2C_3H_7-i$ | O | $CH_3$ | $CH_3$ | 61 | 130–132 | 420 |
| 43 | $CH_2CO_2C_3H_7-i$ | $CH_2CO_2C_3H_7-i$ | O | $C_2H_5$ | $CH_3$ | 56 | 100–104 | 421 |
| 44 | $CH_2CO_2C_3H_7-i$ | $CH_2CH_2CO_2C_3H_7-i$ | O | $C_2H_5$ | H | 56 | 116–117 | 422 |

In those dyes in which Q of structure I is =N- joined with $R^3$, the preparation preferably proceeds as follows: Such dyes are prepared by the condensation of a suitably substituted aryl aldehyde with a suitably substituted ketomethylene compound. The condensations are typically carried out in an alcoholic solvent, i.e., ethanol, and use of a base to promote condensation is almost never necessary. The resulting dye produced sometimes spontaneously crystallizes from the reaction medium, but more frequently, the addition of a nonpolar solvent like ligroin is required to promote precipitation. Purification is usually effected by recrystallization. By such a procedure, preparation No. 45 was prepared as follows:

Preparation No. 45

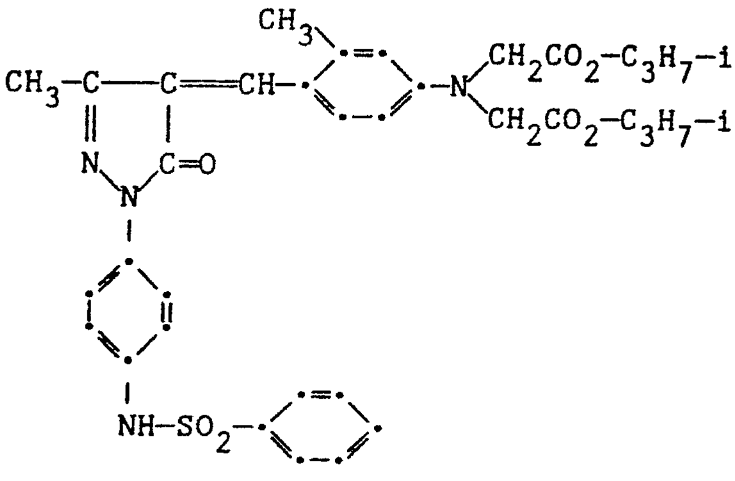

(4-[4-di(isopropoxycarbonylmethyl)amino-2-methylbenzylidene]-3-methyl-1-(4-phenylsulfonamido)phenyl-2-pyrazolin-5-one)

To a solution of 3.3 grams (0.01 mol) of 4-[di(isopropoxycarbonylmethyl]amino-2-methylbenzaldehyde in 25 ml ethanol in a 50 ml round bottom flask was added 3.3 grams (0.01 mol) of 3-methyl-1-(4-phenylsulfonamido)phenyl-2-pyrazolin-5-one. The resulting slurry was stirred and heated to reflux. After 18 hrs. the reaction solution was clear dark orange. Heating was discontinued, the contents of the flask were poured into 100 ml ethanol and chilled in ice for 6 hrs. The resulting red-orange precipitate was filtered off and air dried to give 4.5 grams of crude product. The crude dye was dissolved in 20 ml acetone then 80 ml of isopropyl alcohol was added. The solution was boiled down to a volume of 50 ml whereupon an additional 50 ml of isopropyl alcohol was added and the orange solution was chilled at 2° C for 15 hrs. The resulting red-orange crystals were filtered off, washed with cold isopropyl alcohol, and dried to yield 3.7 grams (5.7 mmol, 57% yield) of pure dye, $\lambda_{max}$ = 436 nm (MeOH), MP = 172-173° C.

Preparations 46-48 were similarly prepared to give:

Preparation No. 46

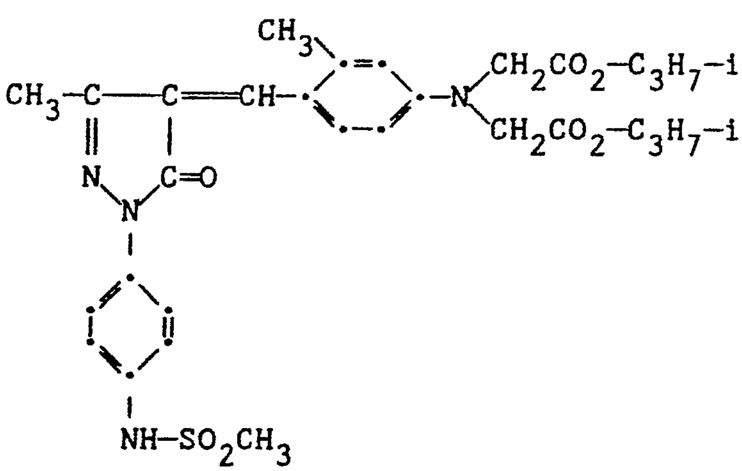

$\lambda_{max}$ (MeOH) = 436 nm, MP = 102-110° C.

Preparation No. 47

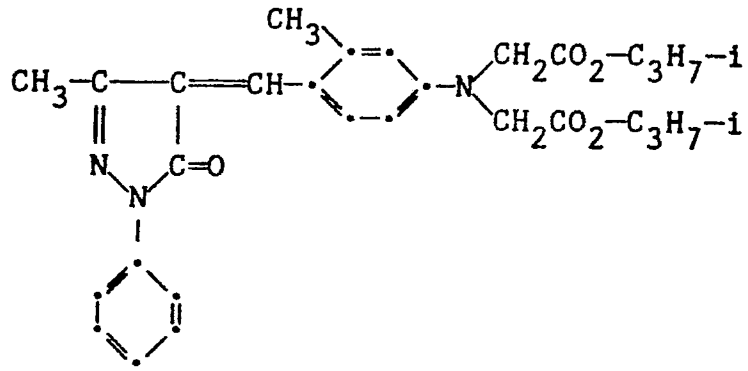

$\lambda_{max}$ (MeOH) = 432, MP = 141-142° C.

Preparation No. 48

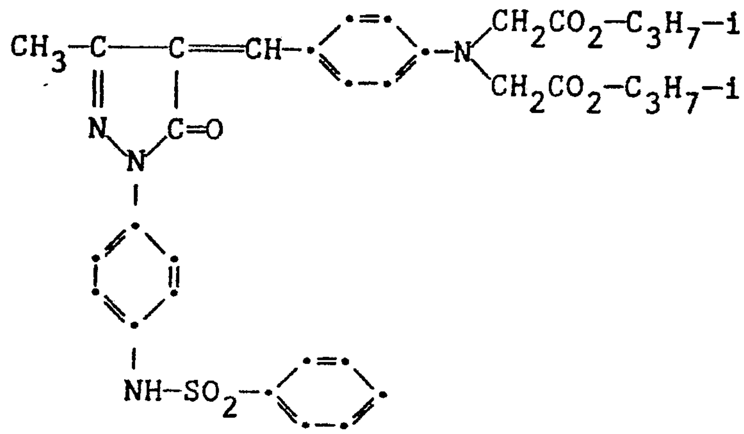

$\lambda_{max}$ (MeOH) = 424, MP = 111-116° C.
(4-[4-di-(isopropoxycarbonylmethyl)amino-2-benzylidene]-3-methyl-1-(4-phenylsulfonamido)phenyl-2-pyrazolin-5-one).

Examples

The following examples further illustrate the invention.

Examples 1-3: Use of Dye Preparation Nos. 18, 42 and 45 in PMMA

The dyes of Preparation Nos. 18, 42 and 45 were dissolved in a 6% solution of poly(methyl methacrylate) in chlorobenzene to provide a w/w concentration of 0.5%. Two comparative examples were prepared identically except that Sudan Orange G, and Curcumin, both commercial dyes commonly used in microelectronic fabrication, were used in place of the dyes of Preparation Nos. 18, 42 and 45. The solutions were then filtered and spin-coated separately onto quartz plates at 3000 RPM to give a thickness, in each case, of about 0.4 µm. These coatings were soft-baked at 100° C for 30 min in a forced air oven to remove solvent, followed by a hard bake at 200° C for 10 min to simulate planarization treatment. Absorption spectra were taken both before and after the hard bake, to determine % loss in density. For the dyes of Preparation Nos. 18, 42 and 45, there was a 5%, 0%, and 7% loss, respectively, in density. However, the Sudan Orange G suffered a total loss in density, and the Curcumin suffered at least 20% loss in density.

Examples 4-6: Speed Loss of Dye Preparation Nos. 18, 42 and 45

A photoresist was obtained wherein the photosensitive compound comprised NDS-capped novolac resin wherein 3 mole % of the hydroxy groups were capped with quinone diazide to have the structural formula A shown above. In addition, the resist included the photosensitive compound

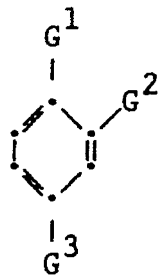

wherein

$G^1$ = 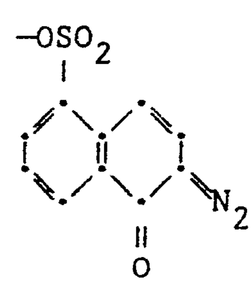

To this was added, in the three different examples, the dyes of Preparation Nos. 18, 42 and 45, respectively, in 0.9% amounts, w/w. Three comparative examples were prepared identically, except the dyes used were Sudan Orange, Curcumin and 4-n-butylamino-1,8-(N,N-butyl)naphthalimide, respectively, at respective concentrations of 0.7%, 0.5% and 4% (w/w).

All the solutions were then spin-coated at 4800 RPM to a thickness of 1.3 µm on 10 cm silicon wafers coated with 2000Å of $SiO_2$ and various aluminum typographies. The wafers were then baked at 100 °C for 30 min to dry. Absorption spectra showed that all coatings had a dye density of about 0.3 at 436 nm. Exposure was then made to a 436 nm light using a TRE 10:1 reduction stepper and a 2.0/2.0 µm line and space mask. All examples were then developed using an automated wafer developer available from GCA under the trademark "Wafertrac", and the Kodak ZX934 (1:1 dilution) developer. Compared to an undyed control, Examples 4-6 produced images with less standing wave effect and without reflective notching.

As to speed loss, comparing the examples against the undyed control, it was found that Examples 4-6 experienced a speed loss of only 5 to 8%. In contrast, the Comparative Examples had a speed loss of 10%, 30%, and 60%, respectively.

## Claims

1. A photoresist composition comprising a positive-working non-silver halide, photosensitive compound and an antireflective dye that absorbs at least some of the radiation that is effective to activate said compound,

   characterized in that said dye has the following structural formula:

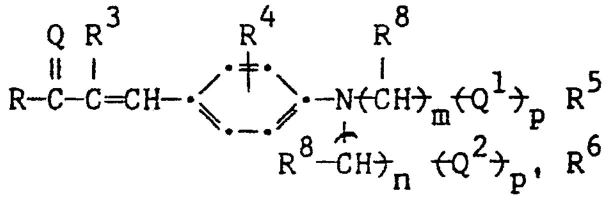

wherein:

R is alkyl of 1-3 carbon atoms or

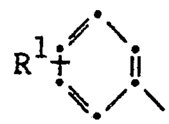

$R^1$ is $R^2SO_2NH$-, $R^2NHSO_2$-, HO-, or $HO_2C$-;

$R^2$ is alkyl of 1-6 carbon atoms or such alkyl substituted with fluorine, or aryl of 6-10 carbon atoms;

Q is =O or =N- joined with $R^3$ to complete a pyrazolone ring;

$R^3$ is -CN, $-NO_2$, $-CF_3$, or

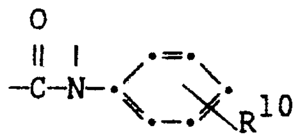

joined with Q to complete said pyrazolone ring;

$R^4$ is H, alkyl of 1-6 carbon atoms; or

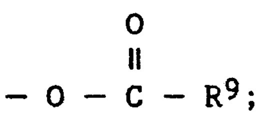

$R^5$ and $R^6$ are individually alkyl or alkyl of 1-5 carbon atoms optionally substituted with fluorine, $-R^7$, or H;

$Q^1$ and $Q^2$ are individually $-CO_2$-, $-O_2C$- or $-SO_2$-;

R is alkyl of 1-3 carbon atoms or aryl of 6-10 carbon atoms;

$R^8$ is H or alkyl of 1-3 carbon atoms;

$R^9$ is H or alkyl of 1-7 carbon atoms;

$R^{10}$ is $-NHSO_2-R^7$ or H;

m and n are individually an integer of from 1 to 5; and

p and p' are individually 0 or 1.

**2.** The composition of claim 1 characterized in that said dye has one of the following structural formulae:

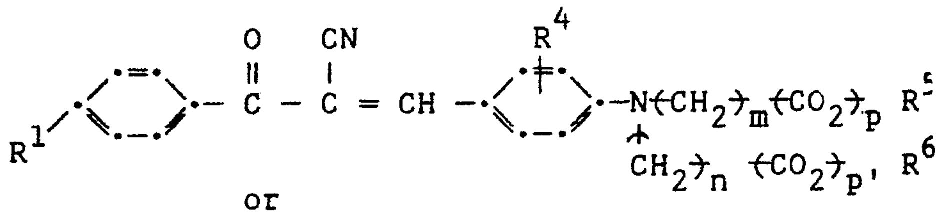

or

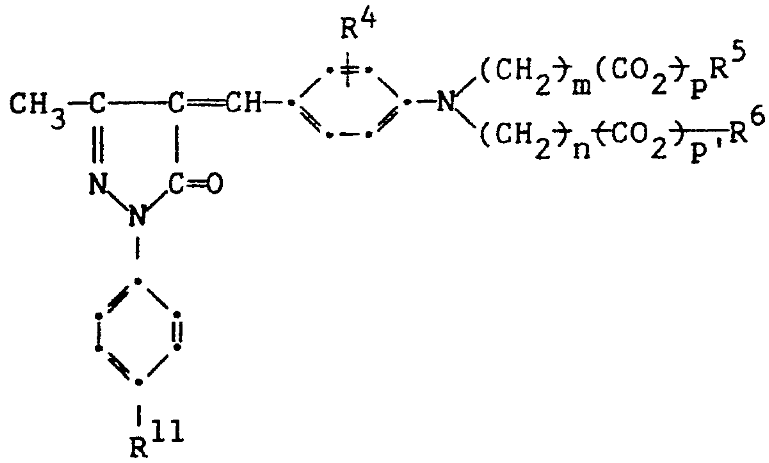

wherein:

$R^1$ is $R^2SO_2NH$-;

$R^2$ is alkyl of 1-6 carbon atoms;

$R^4$ is H or alkyl of 1-6 carbon atoms;

$R^5$ and $R^6$ are individually alkyl of 1-3 carbon atoms or alkyl of 1-3 carbon atoms substituted with fluorine;

$R^{11}$ is

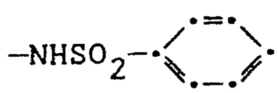

or H;

m and n are 1 or 2; and

p and p' are 0 or 1.

**3.** The composition of claim 1 wherein said dye is selected from the group consisting of:

a) α-cyano-4-[N-ethyl-N-(2,2,2-trifluoroethoxycarbonylmethyl)]amino-2-methyl-4'-propylsulfonamidochalcone;

b) α-cyano-4-[N,N-di(isopropoxycarbonylmethyl)]amino-2-methyl-4'-methylsulfonamidochalcone;

c) α-cyano-4-[N-ethyl-N-(2,2,2-trifluoroethoxycarbonylmethyl)]amino-4'-butylsulfonamidochalcone;

d) α-cyano-4-[N-ethyl-N-(2,2,2-trifluoroethoxycarbonylmethyl)]amino-2-methyl-4'-butylsulfonamidochalcone;

e) α-cyano-4-[N-isopropyl-N-isopropoxycarbonylmethyl]amino-4'-propylsulfonamidochalcone;

f) α-cyano-4-[N,N-di(2-fluoroethyl)]amino-4'-butylsulfonamidochalcone;

g) α-cyano-4-[N,N-di(2-fluoroethyl)]amino-4'-isobutylsulfonamidochalcone;

h) α-cyano-4-(N,N-di(2-fluoroethyl)]amino-4'-pentylsulfonamidochalcone;

i) α-cyano-4-(N,N-di(2-fluoroethyl)]amino-4'-hexylsulfonamidochalcone;

j) α-cyano-4-[N,N-di(isopropoxycarbonylmethyl)]amino-2-methyl-4'-ethylsulfonamidochalcone;

k) α-cyano-4-[N-(2-isopropoxycarbonylethyl)-N-isopropoxycarbonylmethyl]amino-4'-ethylsulfonamidochalcone;

l) 4-[4-di-(isopropoxycarbonylmethyl)amino-2-benzylidene]3-methyl-1-(4-phenylsulfonamido)phenyl-2-pyrazolin-5-one.

4. A method of preventing standing wave ripples and reflective notching in a photoresist composition from radiation reflected back from a support on which the photoresist is coated, the method characterized by the step of incorporating into said photoresist composition, a dye having the structural formula set forth in claim 1.

## Revendications

1. Composition de photoréserve comprenant un composé photosensible à effet positif, ne contenant pas d'halogénures d'argent et un colorant antiréfléchissant qui absorbe au moins une partie du rayonnement qui provoque l'activation dudit composé,
caractérisé en ce que le colorant a la formule suivante :

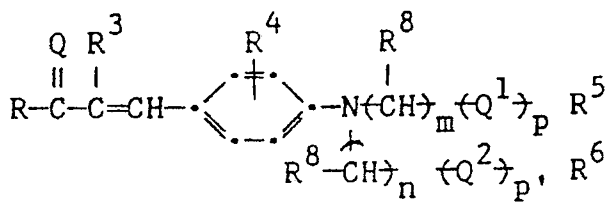

où
R est un alkyle de 1 à 3 atomes de carbone ou

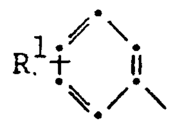

$R^1$ est $R^2SO_2NH$-, $R^2NHSO_2$-, HO-, ou $HO_2C$- ;
$R^2$ est alkyle de 1 à 6 atomes de carbone ou alkyle substitué par du fluor, ou aryle de 6 à 10 atomes de carbone ;
Q est =O ou =N- qui complètent avec $R^3$ un cycle pyrazolone ;
$R^3$ est -CN, $-NO_2$, $-CF_3$, ou

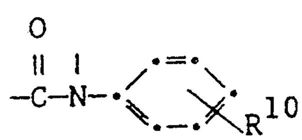

qui complète avec Q un cycle pyrazolone ;
$R^4$ est H, alkyle de 1 à 6 atomes de carbone ou

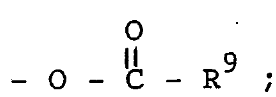

$R^5$ et $R^6$ sont chacun séparément un alkyle ou alkyle de 1 à 5 atomes de carbone qui peut être substitué par du fluor, $-R^7$ ou H ;
$Q^1$ et $Q^2$ sont chacun séparément $-CO_2$-, $-O_2C$- ou $-SO_2$- ;
$R^7$ est alkyle de 1 à 3 atomes de carbone ou aryle de 6 à 10 atomes de carbone ;
$R^8$ est H, ou alkyle de 1 à 3 atomes de carbone ;
$R^9$ est H, ou alkyle de 1 à 7 atomes de carbone ;
$R^{10}$ est $-NHSO_2-R^7$ ou H ;
m et n sont chacun séparément un entier de 1 à 5 ; et
p et p' sont chacun séparément 0 ou 1.

2. Composition selon la revendication 1 caractérisée en ce que ledit colorant a l'une des formules

suivantes :

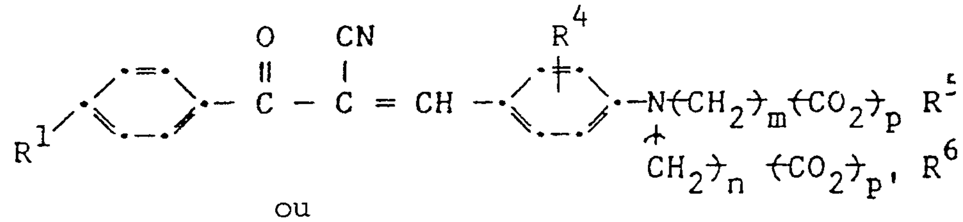

ou

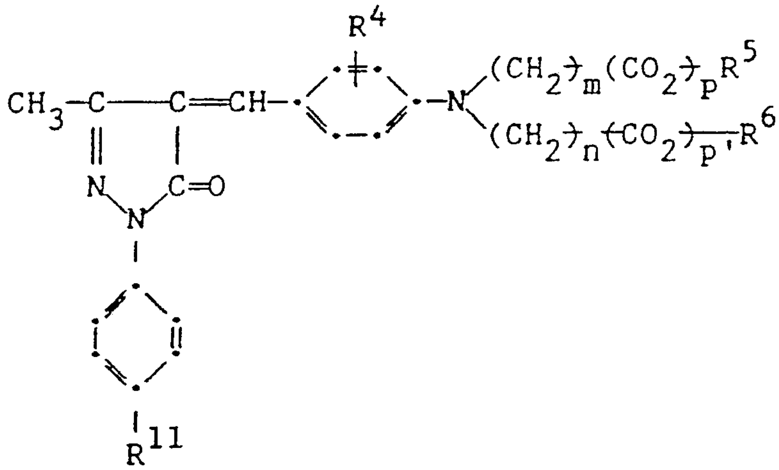

où

$R^1$ est $R^2SO_2NH$- ;

$R^2$ est alkyle de 1 à 6 atomes de carbone ;

$R^4$ est H ou alkyle de 1 à 6 atomes de carbone ;

$R^5$ et $R^6$ sont chacun séparément alkyle de 1 à 3 atomes de carbone ou alkyle de 1 à 3 atomes de carbone substitué par du fluor ;

$R^{11}$ est

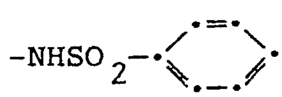

ou H ;

m et n sont 1 ou 2 ; et

p et p' sont 0 ou 1.

3. Composition selon la revendication 1 dans laquelle le colorant est choisi parmi les composés suivants
   a) α-cyano-4-[N-éthyl-N-(2,2,2-trifluoroéthoxycarbonylméthyl)]amino-2-méthyl-4'-propylsulfonamidochalcone ;
   b) α-cyano-4-[N-N-di(isopropoxycarbonylméthyl)]amino-2-méthyl-4'-méthylsulfonamidochalcone ;
   c) α-cyano-4-[N-éthyl-N-(2,2,2-trifluoroéthoxycarbonylméthyl)]amino-4'-butylsulfonamidochalcone ;
   d) α-cyano-4-[N-éthyl-N-(2,2,2-trifluoroéthoxycarbonylméthyl)]amino-2-méthyl-4'-butylsulfonamidochalcone ;
   e) α-cyano-4-[N-isopropyl-N-isopropoxycarbonylméthyl]-amino-4'-propylsulfonamidochalcone ;
   f) α-cyano-4-[N,N-di(2-fluoroéthyl)]amino-4'-butylsulfonamidochalcone ;
   g) α-cyano-4-[N,N-di(2-fluoroéthyl)]amino-4'-isobutylsulfonamidochalcone ;
   h) α-cyano-4-[N,N-di(2-fluoroéthyl)]amino-4'-pentylsulfonamidochalcone ;
   i) α-cyano-4-[N,N-di(2-fluoroéthyl)]amino-4'-hexylsulfonamidochalcone ;
   j) α-cyano-4-[N,N-di(isopropoxycarbonylméthyl)]amino-2-méthyl-4'-éthylsulfonamidochalcone ;
   k) α-cyano-4-[N-(2-isopropoxycarbonyléthyl)-N-isopropoxycarbonylméthyl]amino-4'-éthylsulfonamidochalcone ;

l) 4-[4-di-(isopropoxycarbonyléthyl)amino-2-benzylidène]-3-méthyl-1-(4-phénylsulfonamido)phényl-2-pyrazolin-5-one.

**4.** Procédé permettant de prévenir les ondulations dues aux ondes stationnaires et les entailles parasites dues à des phénomènes de réflexion du rayonnement dans une composition de photoréserve appliquée sur un support, procédé caractérisé en ce qu'on incorpore dans la composition de photoréserve un colorant ayant la formule définie dans la revendication 1.

## Patentansprüche

**1.** Photoresist-Zusammensetzung mit einer positiv arbeitenden, nicht aus Silberhalogenid bestehenden photosensitiven Verbindung sowie einem anti-reflektierenden Farbstoff, der mindestens einen Teil der Strahlung absorbiert, die die Verbindung wirksam aktiviert,

dadurch gekennzeichnet, daß der Farbstoff der folgenden Strukturformel entspricht:

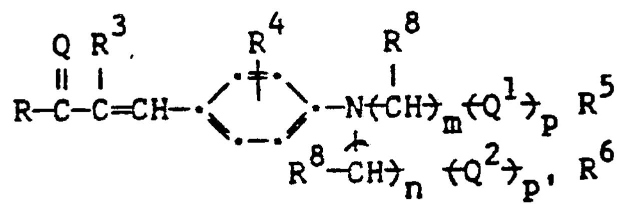

in der bedeuten:

R Alkyl mit 1-3 Kohlenstoffatomen oder einen Rest der Formel

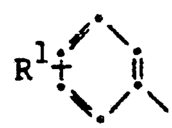

worin $R^1$ steht for $R^2SO_2NH$-, $R^2NHSO_2$- oder HO- oder $HO_2C$-;

$R^2$ gleich Alkyl mit 1-6 Kohlenstoffatomen oder solchem Alkyl, das durch Fluor substituiert ist, oder Aryl mit 6-10 Kohlenstoffatomen;

Q gleich =O oder =N-, das mit $R^3$ einen Pyrazolonring vervollständigt;

$R^3$ gleich -CN, $-NO_2$, $-CF_3$ oder einen Rest der Formel

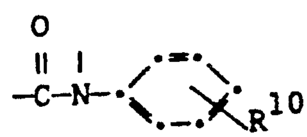

der mit Q den Pyrazolonring vervollständigt;

$R^4$ gleich H, Alkyl mit 1-6 Kohlenstoffatomen oder

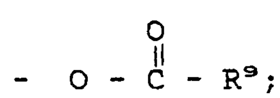

$R^5$ und $R^6$ einzeln Alkyl oder Alkyl mit 1-5 Kohlenstoffatomen, das gegebenenfalls durch Fluor substituiert ist, $-R^7$ oder H;

$Q^1$ und $Q^2$ einzeln $-CO_2$, $-O_2C$- oder $-SO_2$-;

$R^7$ gleich Alkyl mit 1-3 Kohlenstoffatomen oder Aryl mit 6-10 Kohlenstoffatomen;

$R^8$ gleich H oder Alkyl mit 1-3 Kohlenstoffatomen;

| | |
|---|---|
| $R^9$ | gleich H oder Alkyl mit 1-7 Kohlenstoffatomen; |
| $R^{10}$ | gleich $-NHSO_2-R^7$ oder H; |
| m und n | einzeln Zahlen von 1 bis 5 und |
| p und p' | einzeln 0 oder 1. |

2. Zusammensetzung nach Anspruch 1, dadurch gekennzeichnet, daß der Farbstoff einer der folgenden Formeln entspricht:

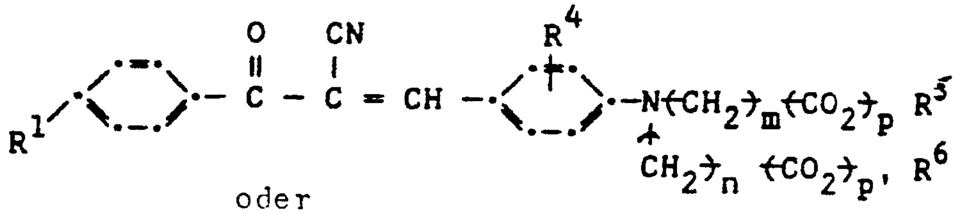

oder

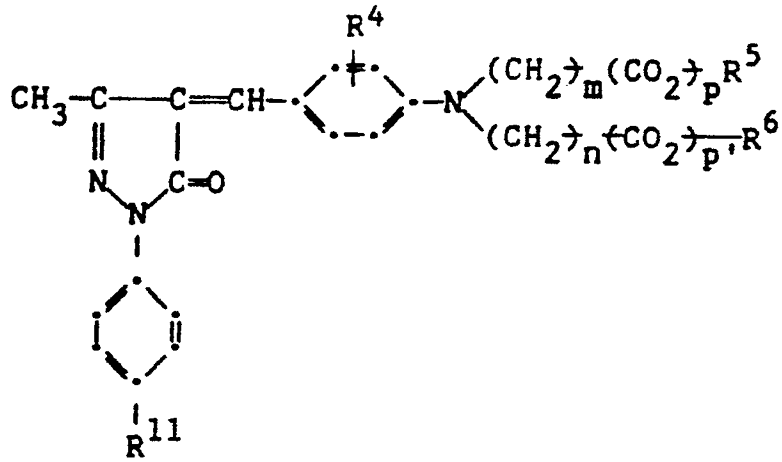

in der bedeuten:

| | |
|---|---|
| $R^1$ | gleich $R^2SO_2NH$-; |
| $R^2$ | gleich Alkyl mit 1-6 Kohlenstoffatomen; |
| $R^4$ | gleich H oder Alkyl mit 1-6 Kohlenstoffatomen; |
| $R^5$ und $R^6$ | einzeln gleich Alkyl mit 1-3 Kohlenstoffatomen oder Alkyl mit 1-3 Kohlenstoffatomen, das durch Fluor substituiert ist; |
| $R^{11}$ | gleich 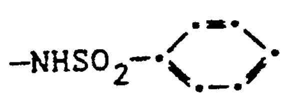 oder H; |
| m und n | gleich 1 oder 2; und |
| p und p' | gleich 0 oder 1. |

3. Zusammensetzung nach Anspruch 1, in der der Farbstoff aus der folgenden Gruppe von Farbstoffen ausgewählt ist:
   a) α-Cyano-4-[N-ethyl-N-(2,2,2-trifluoroethoxycarbonylmethyl)]amino-2-methyl-4'-propylsulfonamidochalcon ;
   b) α-Cyano-4-[N,N-di(isopropoxycarbonylmethyl)]amino-2-methyl-4'-methylsulfonamidochalcon ;
   c) α-Cyano-4-[N-ethyl-N-(2,2,2-trifluoroethoxycarbonylmethyl)]amino-4'-butylsulfonamidochalcon ;
   d) α-Cyano-4-[N-ethyl-N-(2,2,2-trifluoroethoxycarbonylmethyl)]amino-2-methyl-4'-butylsulfonamidochalcon ;
   e) α-Cyano-4-[N-isopropyl-N-isopropoxycarbonylmethyl]amino-4'-propylsulfonamidochalcon ;
   f) α-Cyano-4-[N,N-di(2-fluoroethyl)]amino-4'-butylsulfonamidochalcon ;

g) α-Cyano-4-[N,N-di(2-fluoroethyl)]amino-4'-isobutylsulfonamidochalcon ;
h) α-Cyano-4-[N,N-di(2-fluoroethyl)]amino-4'-pentylsulfonamidochalcon ;
i) α-Cyano-4-[N,N-di(2-fluoroethyl)]amino-4'-hexylsulfonamidochalcon ;
j) α-Cyano-4-[N,N-di(isopropoxycarbonylmethyl)]amino-2-methyl-4'-ethylsulfonamidochalcon ;
k) α-Cyano-4-[N-(2-isopropoxycarbonylethyl)-N-isopropoxycarbonylmethyl]amino-4'-ethylsulfonamidochalcon ;
l) 4-[4-Di-(isopropoxycarbonylmethyl)amino-2-benzylidene]-3-methyl-1-(4-phenylsulfonamido)phenyl-2-pyrazolin-5-on .

4. Verfahren zur Verhinderung des Auftretens von durch stationäre Wellen verursachten Störungen oder eines reflektierenden Zackenschnitts in einer Photoresist-Zusammensetzung, hervorgerufen von Strahlung, die von einem Träger, auf dem die Photoresist-Zusammensetzung aufgetragen ist, gekennzeichnet durch die Stufe der Einarbeitung eines Farbstoffes der Strukturformel des Anspruches 1 in die Photo-resist-Zusammensetzung.